# EUROPÄISCHE PATENTANMELDUNG

(11) **EP 1 247 690 A2**
(43) Veröffentlichungstag der Anmeldung: **09.10.2002**
(21) Anmeldenummer: 02007533.9
(22) Anmeldetag: 03.04.2002
(51) Int. Cl.: B60Q 1/26

(54) **Fahrzeugleuchte**

(30) Priorität: 05.04.2001 DE 10116957
(71) Anmelder: Hella KG Hueck & Co., 59552 Lippstadt (DE)
(72) Erfinder: Sachs-Dücker, Gabriele Monika, 59597 Erwitte (DE); Knaack, Ulrich, 33098 Paderborn (DE); Neumann, Cornelius, 33649 Bielefeld (DE)

(57) **Zusammenfassung**

Die Erfindung betrifft eine Fahrzeugleuchte mit einem Gehäuse (10), einer das Gehäuse (10) abdeckenden Lichtscheibe (12) und zumindest einer, auf einer im Gehäuse (10) angeordneten Platine (14) kontaktierten Lichtquelle (16), die in dem durch das Gehäuse (10) und die Lichtscheibe (12) gebildeten Innenraum (18) angeordnet ist.

Aufgabe der Erfindung ist es, eine Leuchte zu schaffen, bei der auf einer Platine (14) kontaktierte Lichtquellen (16) auf einfache und kostengünstige Weise in Ihrer räumlichen Lage zu auf der Lichtscheibe (12) befindlichen optischen Mitteln (38) fixiert werden, insbesondere bei Leuchten, deren Lichtscheibe (12) lösbar mit dem Leuchtengehäuse verbunden ist.

Diese Aufgabe wird erfindungsgemäß dadurch gelöst, dass die Platine (14) schwimmend und in der Tiefe gegen die Kraft einer Feder (34) beweglich in dem Gehäuse (10) gelagert und über zumindest einen einstückig mit der Lichtscheibe (12) ausgeführten Dorn (20) in ihrer räumlichen Lage fixiert ist.

## Beschreibung

Die Erfindung betrifft eine Fahrzeugleuchte mit einem Gehäuse, einer das Gehäuse abdeckenden Lichtscheibe und zumindest einer, auf einer im Gehäuse angeordneten Platine kontaktierten Lichtquelle, die in dem durch das Gehäuse und die Lichtscheibe gebildeten Innenraum angeordnet ist.

Eine derartige Leuchte ist aus der US 4,862,330 bekannt. Die bekannte Leuchte, die eine in einen Fahrzeugspoiler integrierte Zusatzbremsleuchte ist, weist in ihrem Innenraum eine Vielzahl von LEDs auf, die in Hauptabstrahlrichtung der Leuchte horizontal nebeneinander angeordnet und auf einer Platine elektrisch und mechanisch kontaktiert sind. Die Platine ist von mehreren einstückig mit der rückwärtigen Gehäusewandung ausgeführten, in den Leuchteninnenraum ragenden Dome gehalten. An speziell ausgeformte Dome wird die Platine angeschraubt und somit in ihrer Lage in allen drei Raumwinkeln fixiert. Zusätzlich zu diesen Domen sind an das Leuchtengehäuse noch weitere Dome angeformt, an denen die Platine lediglich anliegt und die so ein Durchbiegen der Platine zwischen den Anschraubpunkten verhindern. Vor den auf der Platine kontaktierten LEDs ist eine das Gehäuse abdeckende und mit dem Gehäuse unlösbar verbundene Lichtscheibe angeordnet, die auf ihrer zu den LEDs hinweisenden Innenseite über optische Mittel in Form von Linsen verfügt. Diese Linsen erzeugen die gewünschte Lichtverteilung für das von den LEDs abgestrahlte Licht. Nachteilig an einem derart vorbekannten Leuchtenaufbau ist es, dass die Lichtquellen in ihrer Lage im Bezug auf das Leuchtengehäuse fixiert sind und die mit optischen Mitteln versehene Lichtscheibe sehr genau auf das Gehäuse abgestimmt und mit dem Gehäuse verbunden werden muss um die optischen Mittel in ihrer vorbestimmten Lage im Bezug auf die Lichtquellen zu positionieren.

Diese Problematik zeigt sich besonders, wenn die Leuchte nicht wie in diesem Fall eine geschlossene Zusatzbremsleuchte ist, sondern beispielhaft ein mit Lichtquellen versehener Träger in einer Leuchte für Nutzkraftwagen eingesetzt wird, bei der die Lichtscheibe lösbar mit dem Leuchtengehäuse verbunden ist und diese lösbare Verbindung gewisse Fertigungs- und Montagetoleranzen mit sich bringt. Bei einem derartigen Leuchtenaufbau ist es sehr schwierig die auf der Lichtscheibe befindlichen optischen Mittel bezüglich der Lichtquellen zu positionieren um so die gewünschte Lichtverteilung zu erzeugen.
Es sind auch Leuchten bekannt, bei denen eine mit LEDs bestückte Platine fest und unlösbar mit der Lichtscheibe verbunden ist. Bei derartigen Leuchten werden zwar die vorbeschriebenen Probleme vermieden, jedoch muss zur elektrischen Kontaktierung der Platine ein Kabel zwischen dem Leuchtengehäuse und der fest mit der Lichtscheibe verbundenen Platine angeordnet sein, welches eine große Länge hat, damit die Lichtscheibe vom Gehäuse abnehmbar ist. Ein derartiges Kabel ist aufgrund der Länge kostenintensiv und benötigt in dem Leuchtengehäuse einen relativ großen Bauraumbedarf. Ein weiterer Nachteil besteht darin, dass bei einer Beschädigung der Lichtscheibe zwangsläufig auch die unlösbar mit der Lichtscheibe verbundene Platine gewechselt werden muss, was die Kosten für einen Austausch der Lichtscheibe wesentlich erhöht.

Aufgabe der Erfindung ist es, eine Leuchte zu schaffen, bei der auf einer Platine kontaktierte Lichtquellen auf einfache und kostengünstige Weise in Ihrer räumlichen Lage zu auf der Lichtscheibe befindlichen optischen Mitteln fixiert werden, insbesondere bei Leuchten, deren Lichtscheibe lösbar mit dem Leuchtengehäuse verbunden ist.

Diese Aufgabe wird erfindungsgemäß dadurch gelöst, dass die Platine schwimmend und in der Tiefe gegen die Kraft einer Feder beweglich in dem Gehäuse gelagert und über zumindest einen einstückig mit der Lichtscheibe ausgeführten Dorn in ihrer räumlichen Lage fixiert ist.

Ein derartiger Leuchtenaufbau bietet den Vorteil, dass die räumliche Lage der zumindest einen Lichtquelle im Bezug auf an die Lichtscheibe angeformte optische Elemente bei der Lichtscheibenmontage selbsttätig justiert und fixiert wird. Durch die selbsttätige Justage der Lichtquelle zur Lichtscheibe und des daraus resultierenden Toleranzausgleichs ist das zulässige Toleranzfeld für die Fertigungs- und Montagetoleranzen der Lichtscheibe und des Leuchtengehäuses vergrößert, was eine erhebliche Kostenreduzierung bedeutet, da die Spritzgießwerkzeuge nicht so exakt ausgeführt werden müssen und die Spritzgießmaschinen für die Lichtscheibe und das Gehäuse mit einer kürzeren Taktzeit arbeiten können.

Bei einer vorteilhaften Ausführungsform der Erfindung greift der zumindest eine Dorn mit seiner Spitze in eine entsprechende Öffnung der Platine ein, so dass die Ausrichtung der Lichtquelle zur Lichtscheibe in der Ebene senkrecht zur Hauptabstrahlrichtung der Lichtquelle auf einfache Weise realisiert ist. Zweckmäßigerweise ist beabstandet von der Spitze des Dorns eine Anschlagfläche für die Platine an den Dorn angeformt, so dass zusätzlich zur Ausrichtung der Lichtquelle zur Lichtscheibe in der Ebene senkrecht zur Hauptabstrahlrichtung der Lichtquelle auch gleichzeitig der Abstand zwischen der Lichtquelle und der Lichtscheibe in Hauptabstrahlrichtung sichergestellt ist. Eine derartige Ausgestaltung des Dorns ermöglicht eine einfache, schnelle und somit kostengünstige Montage der Lichtscheibe an dem Leuchtengehäuse, da die die Lichtquelle tragende Platine bei der Montage der Lichtscheibe selbsttätig in ihrer räumlichen Lage fixiert wird.

Um die Platine in der Tiefe gegen die Kraft einer Feder beweglich in dem Gehäuse zu lagern ist bei einer bevorzugten Ausgestaltung der Fahrzeugleuchte zwischen dem Gehäuseboden und der Platine ein auf Druck beaufschlagbares Federelement angeordnet. Diese Federelement drückt die Platine gegen die Anschlagfläche des Dorns, so dass der Abstand zwischen der Lichtquelle und der Lichtscheibe dauerhaft festgelegt ist. Bei einer vorteilhaften Ausführungsform ist das Federelement von einem oder mehreren einstückig an das aus Kunststoff hergestellte Gehäuse angeformten dünnwandigen, leicht ausbiegbaren Vorsprüngen gebildet, was den Vorteil bietet, dass kein zusätzliches Bauteil in das Gehäuse eingesetzt werden muss und dadurch kein zusätzlicher Montageschritt erforderlich ist. Das Federelement ist bei einer weiteren vorteilhaften Ausgestaltung der Erfindung von einem oder mehreren an der zum Gehäuseboden weisenden Seite der Platine angeordneten leicht ausbiegbaren Vorsprüngen gebildet, was ebenfalls den Montageschritt für das Einlegen des Federelementes einspart und wobei kein aufwendiges Spritzgießwerkzeug für das Leuchtengehäuse erforderlich ist, da keine zusätzlichen Bauteile an das Gehäuse angeformt sind. Bei einer weiteren Ausführungsform der Fahrzeugleuchte ist das Federelement von einer oder mehreren zwischen dem Gehäuseboden und der Platine eingelegten Federn gebildet, wodurch vorteilhaft die Platine und das Gehäuse sehr einfach und kostengünstig ausgestaltet sind. Zweckmäßigerweise ist die Platine durch im Gehäuse angeformte Rastvorsprünge oder plastisch verformte Vorsprünge schwimmend in dem Gehäuse gelagert, um eine schwimmende Lagerung in der Ebene senkrecht zur Hauptabstrahlrichtung zu gewährleisten, damit die Lichtquelle bei der Lichtscheibenmontage in ihrer räumlichen Lage justiert und fixiert wird.

Eine besonders vorteilhafte Ausführungsform der Erfindung sieht vor, dass die Platine bei nicht montierter Lichtscheibe von dem Federelement gegen die Rastvorsprünge oder plastisch verformten Vorsprünge des Gehäuses und bei montierter Lichtscheibe gegen Anschlagflächen des Dorns gepresst ist, wodurch die Platine auch ohne montierte Lichtscheibe in dem Gehäuse gehalten ist und gleichzeitig die relative Position der Lichtquelle zu den Optikelementen bei der Lichtscheibenmontage erzeugt wird.

Das zwischen Gehäuseboden und Platine angeordnete Federelement erzeugt über die Platine nur soviel Gegendruck auf den zumindest einen Dorn, dass die Platine fest an Anschlagflächen des Dorns anliegt jedoch keine Spannungen in der Lichtscheibe erzeugt werden.

Die zumindest eine auf der Platine kontaktierte Lichtquelle ist vorteilhafterweise eine LED, wodurch eine Fahrzeugleuchte realisiert ist, die wenig Bauraum benötigt und die mit einer Lichtquelle ausgestattet ist, die eine lange Lebensdauer hat und über eine den gesetzlichen Anforderungen entsprechende Lichtstärke verfügt.

Eine vorteilhafte Ausgestaltung der Erfindung wird in den Zeichnungen verdeutlicht. Und zwar zeigen
- Fig. 1:: eine Ansicht auf eine Fahrzeugleuchte,
- Fig. 2:: eine geschnittene Seitenansicht der Leuchte entlang der Linie x-x von Figur 1,
- Fig. 3:: eine geschnittene Seitenansicht der Leuchte entlang der Linie y-y von Figur 1,
- Fig. 4:: einen Ausschnitt der in Figur 3 gezeigten Ansicht in einer anderen Ausführungsform und
- Fig. 5:: einen Ausschnitt der in Figur 3 gezeigten Ansicht in einer weiteren Ausführungsform.

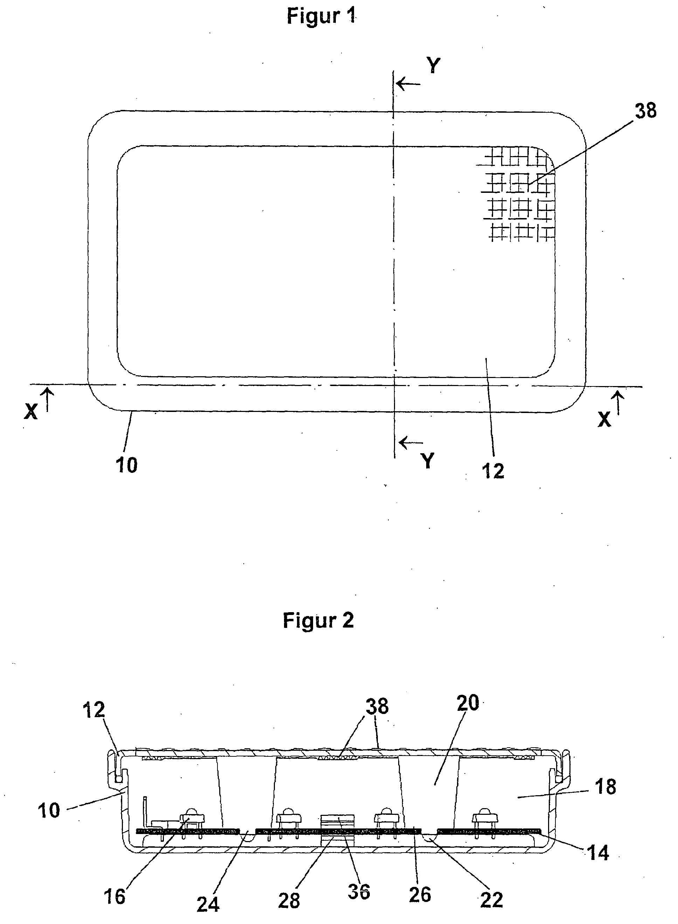

Eine erfindungsgemäße Fahrzeugleuchte besteht, wie aus Figur 1 und 2 ersichtlich, aus einem Gehäuse (10) und einer das Gehäuse (10) abdeckenden Lichtscheibe (12). Die Lichtscheibe (12) ist an ihrer Innen- und Außenseite mit optischen Mitteln (38) versehen, die die gewünschte Lichtverteilung realisieren.

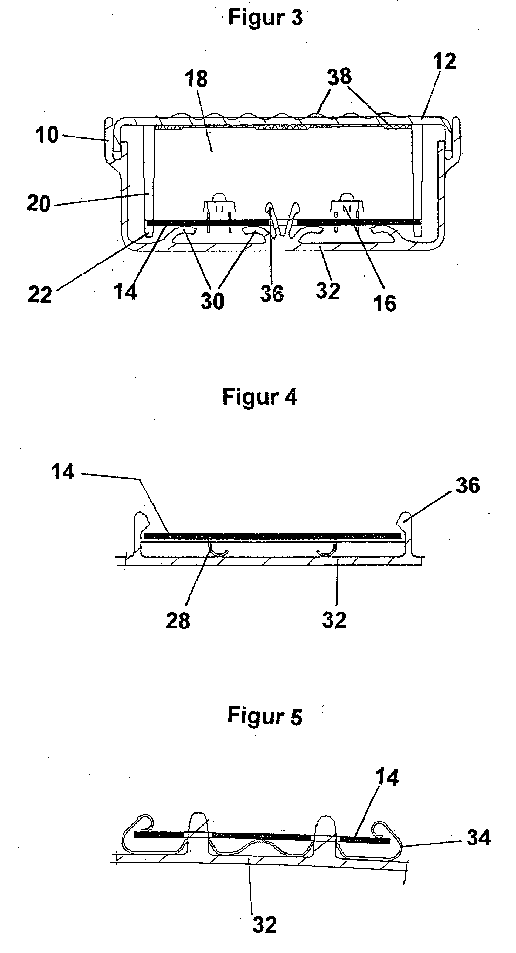

In dem durch das Gehäuse (10) und die Lichtscheibe (12) gebildeten Innenraum (18) ist eine Platine (14) angeordnet, auf der mehrere Lichtquellen (16) in Form von LEDs elektrisch und mechanisch kontaktiert sind. Die Platine (14) ist in der Tiefe gegen die Kraft eines Federelementes (28) beweglich und in der Ebene senkrecht zur Hauptabstrahlrichtung durch Rastvorsprünge (36) schwimmend in dem Gehäuse (10) gehalten. An die Lichtscheibe (12) sind in Richtung des Innenraumes (18) weisende Dorne (20) angeformt, deren Spitzen (22) formschlüssig in entsprechende Öffnungen (24) der Platine (14) eingreifen und so die Lage der Platine (14) in der Ebene senkrecht zur Hauptabstrahlrichtung festlegen, Beabstandet von der Spitze (22) ist eine Anschlagfläche (26) an jeden Dorn (20) angeformt, an der die Platine (14) durch die Gegenkraft des Federelementes (28) anliegt und die in Hauptabstrahlrichtung den Abstand zwischen den auf der Platine (14) kontaktierten Lichtquellen (16) und den auf der Lichtscheibe (12) befindlichen optischen Mitteln (38) bestimmt. Somit sind die auf der Platine (14) kontaktierten Lichtquellen (16) allein durch das Aufsetzen der Lichtscheibe (12) auf das Gehäuse (10) in ihrer räumlichen Lage im Bezug auf die optischen Mittel (38) festgesetzt. Wie in Figur 3 gezeigt, wird das die Platine (14) in Hauptabstrahlrichtung drückende Federelement (28) von mehreren einstückig an den aus Kunststoff hergestellten Gehäuseboden (32) angeformten dünnwandigen, leicht ausbiegbaren Vorsprüngen (30) gebildet. Diese Vorsprünge (30) drücken die Platine (14) derart gegen die Anschlagflächen (26) der Dorne (20), dass die räumliche Lage der Platine (14) dauerhaft festgelegt ist. Damit die Platine (14) vor der Montage oder bei einer evtl. Demontage der Lichtscheibe (12) in dem Gehäuse (10) verbleibt, sind an den Gehäuseboden (32) Rastvorsprünge (36) angeformt, die die Platine (14) halten. Die Rastvorsprünge (36) sind so dimensioniert, dass sie die Platine (14) nur vorfixieren und ihr genügend Spielraum geben, damit ihre räumliche Lage nur durch die an die Lichtscheibe (12) angeformten Dorne (20) bestimmt wird. Figur 4 zeigt eine andere Ausführungsform der erfindungsgemäßen Fahrzeugleuchte. An der Platine (14) sind zwei in Richtung des Gehäusebodens (32) weisende leicht ausbiegbare Federelemente (28) angeordnet, die die Platine (14) in Hauptabstrahlrichtung drücken. Seitliche der Platine (14) sind an den Gehäuseboden (32) Rastvorsprünge (36) angeformt, die die Platine (14), wie bereits beschrieben, schwimmend vorfixieren. Der weitere Aufbau der Fahrzeugleuchte entspricht dem in Figur 1 bis 3 gezeigten Aufbau und ist in Figur 4 weggelassen. Figur 5 zeigt eine weitere Ausführungsform der erfindungsgemäßen Fahrzeugleuchte. Bei dieser Ausführungsform ist eine Feder (34) zwischen der Platine (14) und dem Gehäuseboden (32) eingelegt, die so geformt ist, dass sie die Funktion der Federelemente (28) und die Funktion der Rastvorsprünge (36) der anderen gezeigten Ausführungsformen erfüllt. Der weitere Aufbau der Fahrzeugleuchte entspricht dem in Figur 1 bis 3 gezeigten Aufbau und ist in Figur 5 weggelassen.

### Bezugszeichenliste:

- 10: Gehäuse
- 12: Lichtscheibe
- 14: Platine
- 16: Lichtquelle
- 18: Innenraum
- 20: Dorn
- 22: Spitze
- 24: Öffnung
- 26: Anschlagfläche
- 28: Federelement
- 30: Vorsprung
- 32: Gehäuseboden
- 34: Feder
- 36: Rastvorsprung
- 38: optische Mittel

## Patentansprüche

1. Fahrzeugleuchte mit einem Gehäuse, einer das Gehäuse abdeckenden Lichtscheibe und zumindest einer, auf einer im Gehäuse angeordneten Platine kontaktierten Lichtquelle, die in dem durch das Gehäuse und die Lichtscheibe gebildeten Innenraum angeordnet ist, **dadurch gekennzeichnet, dass** die Platine schwimmend und in der Tiefe gegen die Kraft einer Feder beweglich in dem Gehäuse gelagert und über zumindest einen einstückig mit der Lichtscheibe ausgeführten Dorn in ihrer räumlichen Lage fixiert ist.

2. Fahrzeugleuchte nach Anspruch 1, **dadurch gekennzeichnet, dass** der zumindest eine Dorn mit seiner Spitze in eine entsprechende Öffnung der Platine eingreift.

3. Fahrzeugleuchte nach einem der vorstehenden Ansprüche, **dadurch gekennzeichnet, dass** von der Spitze des Dorns beabstandet eine Anschlagfläche für die Platine an den Dorn angeformt ist.

4. Fahrzeugleuchte nach einem der vorstehenden Ansprüche, **dadurch gekennzeichnet, dass** ein auf Druck beaufschlagbares Federelement zwischen dem Gehäuseboden und der Platine angeordnet ist.

5. Fahrzeugleuchte nach Anspruch 4, **dadurch gekennzeichnet, dass** das Federelement von einem oder mehreren einstückig an das aus Kunststoff hergestellte Gehäuse angeformten dünnwandigen, leicht ausbiegbaren Vorsprüngen gebildet ist.

6. Fahrzeugleuchte nach Anspruch 4, **dadurch gekennzeichnet, dass** das Federelement von einem oder mehreren an der zum Gehäuseboden weisende Seite der Platine angeordneten leicht ausbiegbaren Vorsprüngen gebildet ist.

7. Fahrzeugleuchte nach Anspruch 4, **dadurch gekennzeichnet, dass** das Federelement von einer oder mehreren zwischen dem Gehäuseboden und der Platine eingelegten Federn gebildet ist.

8. Fahrzeugleuchte nach einem der vorstehenden Ansprüche, **dadurch gekennzeichnet, dass** die Platine durch im Gehäuse angeformte Rastvorsprünge oder plastisch verformte Vorsprünge schwimmend in dem Gehäuse gelagert ist.

9. Fahrzeugleuchte nach einem der vorstehenden Ansprüche, **dadurch gekennzeichnet, dass** die Platine bei nicht montierter Lichtscheibe von dem Federelement gegen die Rastvorsprünge oder plastisch verformten Vorsprünge des Gehäuses und bei montierter Lichtscheibe gegen Anschlagflächen des Dorns gepresst ist.

10. Fahrzeugleuchte nach einem der vorstehenden Ansprüche, **dadurch gekennzeichnet, dass** die zumindest eine Lichtquelle eine LED ist.
